# EUROPEAN PATENT SPECIFICATION

(11) **EP 3 653 750 B1**
(45) Date of publication and mention of the grant of the patent: **21.08.2024**
(21) Application number: 18831577.4
(22) Date of filing: 22.06.2018
(51) Int. Cl.: C23C 16/54, C23C 16/04, C23C 16/44

(54) **DEVICE AND METHOD FOR COATING SURFACE OF POROUS SUBSTRATE**
VORRICHTUNG UND VERFAHREN ZUR BESCHICHTUNG EINER OBERFLÄCHE EINES PORÖSEN SUBSTRATS
DISPOSITIF ET PROCÉDÉ DE REVÊTEMENT DE LA SURFACE D'UN SUBSTRAT POREUX

(30) Priority: 12.07.2017 KR 20170088402
(43) Date of publication of application: 20.05.2020
(73) Proprietor: LG Chem, Ltd., Seoul 07336 (KR)
(72) Inventor: PARK, Sang Joon, Daejeon 34122 (KR); KIM, Jong Seok, Daejeon 34122 (KR); LEE, Eun Jeong, Daejeon 34122 (KR); KIM, Sung Su, Daejeon 34122 (KR); LEE, Jae In, Daejeon 34122 (KR); CHO, Eun Byurl, Daejeon 34122 (KR)
(74) Representative: Hoffmann Eitle
(86) International application number: PCT/KR2018/007058
(87) International publication number: WO 2019/013465

(56) References cited:
- EP-A1- 3 056 477
- EP-A2- 0 695 622
- JP-A- H0 718 451
- KR-A- 20170 071 856
- US-A- 4 609 562
- US-A1- 2003 003 233
- US-A1- 2014 037 853
- US-A1- 2014 220 244
- US-A1- 2017 167 020

## Description

### Technical Field

The present invention relates to an apparatus and a method for coating a surface of a porous substrate.

### Background Art

As a method of forming a film on a substrate, there is, for example, an atomic layer deposition method.

The atomic layer deposition (ALD) is a technique for forming a film on a substrate based on the sequential use of chemical substances, which are usually in a gas phase, which is applied to various fields.

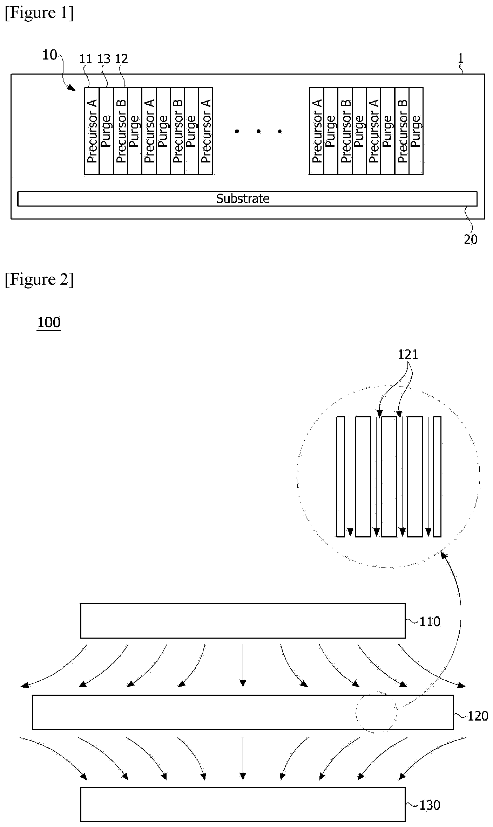

Figure 1 is a schematic diagram showing a general atomic layer deposition apparatus (1), and particularly shows a spatial division type atomic layer deposition apparatus (1).

The atomic layer deposition apparatus (1) comprises a gas distribution plate (10) having a plurality of supply ports (11, 12, 13) and a transport device for transporting a substrate (20). The gas distribution plate (10) has precursor gas supply ports (11, 12) for supplying one or more precursor gases (precursor A, B) (also referred to as 'source gas') onto the substrate (20), and a purge gas supply port (13) for supplying a purge gas.

In addition, the atomic layer deposition method is advantageous for surface coating of pores in the porous substrate due to its high coatability. However, when the porous substrate becomes thick, supply and diffusion of the source gas into the pores, and purge and removal of reactive by-products are not smooth and thus uniform coating becomes difficult.

Specifically, depending on the pore size, the aspect ratio, or the surface characteristics of the porous substrate, the gas supply or diffusion into the pores may not be smooth, and accordingly, unevenness of the deposited thickness and composition may occur along the depth direction (thickness direction) of the porous substrate.

A method for depositing a layer of material on a permeable substrate is disclosed in US 2014/037853. The method involves passing the substrate between a set of reactors injecting source precursor, reactant precursor, purge gas or a combination thereof onto the substrate as the substrate passes between the reactors, while part of the gas injected by a reactor penetrates the substrate and is discharged by the other reactor.

### Disclosure

### Technical Problem

It is a problem to be solved by the present invention to provide an apparatus and a method for coating a surface of a porous substrate which can uniformly coat the surface of the porous substrate.

### Technical Solution

To solve the above-described problem, according to one aspect of the present invention, there is provided an apparatus for coating a surface of a porous substrate having a first surface and a second surface opposite to the first surface, which comprises: a first supply part for supplying a source gas to the first surface of the porous substrate; a first pumping part for generating a flow current inside the porous substrate in the direction from the first surface of the porous substrate toward the second surface; a second supply part for supplying the source gas to the second surface of the porous substrate; a second pumping part for generating a flow current inside the porous substrate in the direction from the second surface of the porous substrate toward the first surface; and a substrate carrier for transporting the substrate which is provided so as to transport a discontinuous substrate; wherein the first supply part and the second supply part are disposed in order along the transport direction of the substrate on either the upper part or the lower part of the substrate, and the first pumping part and the second pumping part are disposed in order along the transport direction of the substrate on the other part of the upper part or the lower part of the substrate, characterized in that the apparatus comprises a substrate reverse part for reversing the first surface and the second surface of the substrate passing through the first supply part, and the substrate carrier has one or more openings for passing the flow current in at least some regions.

Also, the first supply part and the first pumping part may be disposed to face each other on the basis of the substrate.

Furthermore, the second supply part and the second pumping part may be disposed to face each other on the basis of the substrate..

Furthermore, the first supply part and the second supply part may be arranged in order along the transport direction of the substrate, and the first pumping part and the second pumping part may be arranged in order along the transport direction of the substrate.

The substrate carrier has one or more openings for passing the flow current in at least some regions. The substrate carrier is provided to discontinuously transport the substrate upon passing through the first and second supply parts.

Also, the apparatus further comprises a substrate reverse part for reversing the first surface and the second surface of the substrate passing through the first supply part.

At this time, the first supply part and the second supply part may be disposed on either the upper part or the lower part of the substrate in order along the transport direction of the substrate, and the first pumping part and the second pumping part may be disposed on the other part of the upper part or the lower part of the substrate in order along the transport direction of the substrate.

In addition, according to another aspect of the present invention, there is provided a method for coating a surface of a porous substrate by using the apparatus of the first aspect of the invention by generating a flow current inside pores in the porous substrate having a first surface and a second surface opposite to the first surface, which comprises steps of: transporting the porous substrate; supplying and diffusing a source gas in the direction from the first surface of the porous substrate toward the second surface, and removing reactive by-products and the remaining source after the reaction; and supplying and diffusing the source gas in the direction from the second surface of the porous substrate toward the first surface, and removing reactive by-products and the remaining source after the reaction.

### Advantageous Effects

As described above, the apparatus and the method for coating a surface of a porous substrate related to at least one embodiment of the present invention have the following effects.

Supply and diffusion of the source gas are smoothly performed on both surfaces of the porous substrate by allowing the direction where the source gas is supplied and the flow current direction formed inside the porous substrate to sequentially pass through different spaces along the transport direction of the porous substrate, whereby the unevenness of the deposited thickness and composition can be improved.

Furthermore, the degree of deposition on both surfaces (front surface, back surface) of the porous substrate can be optionally controlled.

### Brief Description of Drawings

Figure 1 is a schematic diagram showing a general atomic layer deposition apparatus.
Figure 2 is a schematic diagram showing a surface coating apparatus of a porous substrate which is not in accordance with the present invention.
Figure 3 is a schematic diagram showing a surface coating apparatus of a porous substrate related to a second embodiment of the present invention.
Figure 4 is an enlarged diagram of Part A in Figure 3.
Figure 5 is an enlarged diagram of Part B in Figure 3.

### Mode for Invention

Hereinafter, an apparatus and a method for coating a surface of a porous substrate according to one embodiment of the present invention will be described in detail with reference to the accompanying drawings.

In addition, the same or similar reference numerals are given to the same or corresponding components regardless of reference numerals, of which redundant explanations will be omitted, and for convenience of explanation, the size and shape of each constituent member as shown may be exaggerated or reduced.

In this document, the surface coating apparatus of a porous substrate (hereinafter, also referred to as `coating apparatus') may be an atomic layer deposition apparatus, but is not limited thereto, which can also be applied to various deposition methods in which coating is performed by formation of a flow current, for example, chemical vapor deposition, molecular layer deposition, or deposition by a combination thereof.

Figure 2 is a schematic diagram showing a surface coating apparatus (100) of a porous substrate which is not in accordance with the present invention.

The coating apparatus (100) is an apparatus for coating a surface of a porous substrate having a first surface and a second surface opposite to the first surface, which comprises: a source gas supply part (110) for supplying a source gas to the first surface of the porous substrate (20) and a source gas pumping part (130) for generating a flow current in the porous substrate interior (pores, 121) in the direction from the first surface of the porous substrate (120) toward the second surface.

Accordingly, the source gas is injected toward the first surface side of the porous substrate (120), and simultaneously the flow current directed from the first surface side toward the second surface side is generated in the pores of the porous substrate (120) through the source gas pumping part (130), whereby injection and diffusion of the source gas into the inside of the porous substrate (120) are smooth.

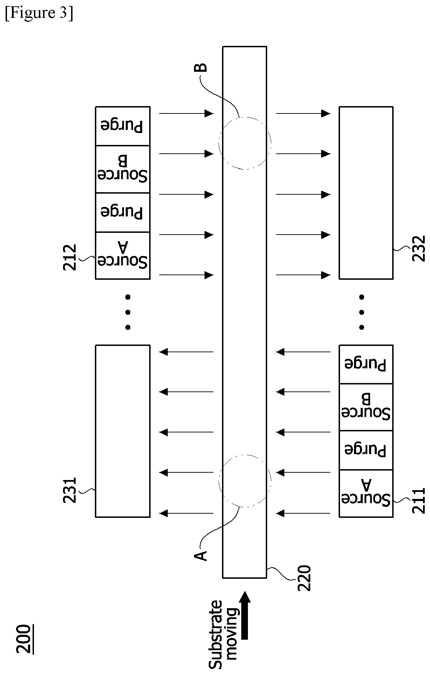

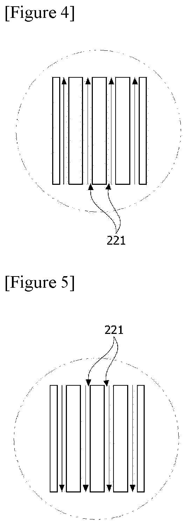

Figure 3 is a schematic diagram showing a surface coating apparatus (200) of a porous substrate according to the present invention, Figure 4 is an enlarged diagram of Part A in Figure 3, and Figure 5 is an enlarged diagram of Part B in Figure 3.

The coating apparatus (200) of the invention is an apparatus for coating a surface of a porous substrate having a first surface (e.g., front surface) and a second surface (e.g., back surface) opposite the first surface.

The coating apparatus (200) comprises a first supply part (211) for supplying a source gas to a first surface of a porous substrate (220) and a first pumping part (231) for generating a flow current inside the porous substrate (220) in the direction from the first surface of the porous substrate (220) toward the second surface.

The coating apparatus (200) also comprises a second supply part (212) for supplying a source gas to the second surface of the porous substrate (220) and a second pumping part (232) for generating a flow current inside the porous substrate (220) in the direction from the second surface of the porous substrate (220) toward the first surface.

The coating apparatus (200) also comprises a substrate carrier (not shown) for transporting the substrate (220). At this time, the substrate carrier has one or more openings for passing the flow current in at least some regions. For example, the substrate carrier may also be configured in the form of a mesh or grill having a predetermined aperture ratio. Alternatively, the substrate carrier may also be configured in a roll-to-roll manner to comprise a plurality of guide rolls. In such a structure, in order to form openings for passing the flow current, the roll-to-roll apparatus may also be configured so as to support both side edges of the substrate in the width direction.

On the other hand, on the basis of Figure 3, the region where the first pumping part (231) and the second supply part (212) are disposed may be referred to as the upper part of the substrate (220), and the region where the first supply part (211) and the second pumping part (232) are disposed may be referred to as the lower part of the substrate (220).

The first and second supply parts (211, 212) are provided so as to inject the source gas onto the substrate, which comprise one or more source gas (source A, source B) injection ports and purge gas injection ports.

Specifically, each of the supply parts (211, 212) may comprise pretreatment gas injection ports, source gas injection ports, and purge gas injection ports. For example, in the supply part, a pretreatment gas injection port, a first precursor (source A) injection port, a purge gas injection port, a second precursor (source B) injection port, and a purge gas injection port may be arranged. In addition, the pretreatment gas injection port may have a plurality of different gas injection ports. Furthermore, plasma or organic vapor may be supplied through the pretreatment gas injection port.

Also, the first supply part (211) and the first pumping part (231) may be disposed to face each other on the basis of the substrate (220). For example, when the source gas is injected to the first surface side of the substrate through the first supply part (211), the first pumping part (231) generates the flow current directed from the first surface toward the second surface in pores (221) inside the porous substrate, whereby the coating can be achieved inside the pores.

Furthermore, the second supply part (212) and the second pumping part (232) may be disposed to face each other on the basis of the substrate. For example, when the source gas is injected to the second surface side of the substrate (220) through the second supply part (212), the second pumping part (232) generates the flow current directed from the second surface toward the first surface in pores (221) inside the porous substrate, whereby the coating can be achieved inside the pores.

Referring to Figures 3 to 5, supply and diffusion of the source gas are smoothly performed on both surfaces (first surface and second surface) of the porous substrate (200) by allowing the direction where the source gas is supplied and the flow current direction (see arrows in Figures 4 and 5) formed inside the porous substrate to sequentially pass through different spaces along the transport direction of the porous substrate (220).

On the other hand, the first pumping part (231) and the second pumping part (232) may be provided to form a flow current with the same pressure. Alternatively, the first pumping part (231) and the second pumping part (232) may also be provided to form a flow current with different pressures. Thus, the degree of deposition of the porous substrate (220) on both surfaces (front surface, back surface) can be optionally controlled.

The substrate carrier is provided to transport a discontinuous substrate. The discontinuous substrate may be a wafer or glass. Therefore, the coating apparatus (200) further comprises a substrate reverse part (not shown) for reversing the first surface and the second surface of the substrate passing through the first supply part (211).

The first supply part (211) and the second supply part (212) are disposed in order along the transport direction of the substrate on either the upper part or the lower part of the substrate. For example, the first supply part (211) and the second supply part (212) may be disposed together on the upper part of the substrate or on the lower part.

Similarly, the first pumping part (231) and the second pumping part (232) are disposed in order along the transport direction of the substrate (220) on the other part of the upper part or the lower part of the substrate.

For example, the first pumping part (231) and the second pumping part (232) may be disposed together on the upper part of the substrate (220) or on the lower part. Of course, when the first and second supply parts (211, 212) are disposed on the upper part of the substrate (220), the first pumping part (231) and the second pumping part (232) may be disposed on the lower part of the substrate (220).

Also, the first supply part (211) and the first pumping part (231) may be arranged to face each other on the basis of the substrate (220), and the second supply part (212) and the second pumping part (232) may be arranged to face each other on the basis of the substrate (220).

The coating method using the coating apparatus (200) having the above structure is as follows.

The coating method is a method for coating a surface of a porous substrate by using the apparatus in accordance with the invention by generating a flow current inside pores in the porous substrate having a first surface and a second surface opposite to the first surface, which comprises steps of: transporting the porous substrate; supplying and diffusing a source gas in the direction from the first surface of the porous substrate toward the second surface, and removing reactive by-products and the remaining source after the reaction; and supplying and diffusing the source gas in the direction from the second surface of the porous substrate toward the first surface, and removing reactive by-products and the remaining source after the reaction.

For example, the surface coating method of a porous substrate is a method for coating a surface of a porous substrate having a first surface and a second surface opposite to the first surface, which comprises steps of: transporting the porous substrate; supplying and diffusing a source gas to the first surface of the porous substrate; and generating a flow current inside the porous substrate in the direction from the first surface of the porous substrate toward the second surface.

In addition, the method comprises steps of: supplying and diffusing a source gas to the second surface of the porous substrate; and generating a flow current inside the porous substrate in the direction from the second surface of the porous substrate toward the first surface.

The preferred embodiments of the present invention as described above are disclosed for exemplary purpose, where those skilled in the art having ordinary knowledge for the present invention can make various corrections, modifications and additions within the scope of the present claims.

### Industrial Applicability

According to the surface coating apparatus and method of the porous substrate related to at least one embodiment of the present invention, supply and diffusion of the source gas are smoothly performed on both surfaces of the porous substrate, whereby the unevenness of the deposited thickness and composition can be improved.

## Claims

1. A coating apparatus (200) for coating a surface of a porous substrate (220) having a first surface and a second surface opposite to the first surface, which comprises:
a first supply part (211) for supplying a source gas to the first surface of the porous substrate (220);
a first pumping part (231) for generating a flow current inside the porous substrate (220) in the direction from the first surface of the porous substrate (220) toward the second surface;
a second supply part (212) for supplying the source gas to the second surface of the porous substrate (220);
a second pumping part (232) for generating a flow current inside the porous substrate (220) in the direction from the second surface of the porous substrate (220) toward the first surface; and
a substrate carrier for transporting the substrate (220) which is provided so as to transport a discontinuous substrate;
wherein the first supply part (211) and the second supply part (212) are disposed in order along the transport direction of the substrate (220) on either the upper part or the lower part of the substrate, and the first pumping part (231) and the second pumping part (232) are disposed in order along the transport direction of the substrate (220) on the other part of the upper part or the lower part of the substrate (220),
**characterized in that**
the apparatus (200) comprises a substrate reverse part for reversing the first surface and the second surface of the substrate passing through the first supply part (211), and
the substrate carrier has one or more openings for passing the flow current in at least some regions.

2. The apparatus (200) for coating a porous substrate (220) according to claim 1,
wherein the first supply part (211) and the first pumping part (231) are disposed to face each other on the basis of the substrate (220).

3. The apparatus (200) for coating a porous substrate (220) according to claim 1,
wherein the second supply part (212) and the second pumping part (232) are disposed to face each other on the basis of the substrate (220).

4. The apparatus (200) for coating a porous substrate (220) according to claim 1,
wherein the first supply part (211) and the second supply part (212) are arranged in order along the transport direction of the substrate (200), and
the first pumping part (231) and the second pumping part (232) are arranged in order along the transport direction of the substrate.

5. The apparatus (200) for coating a porous substrate (220) according to claim 1,
wherein the first supply part (211) comprises pretreatment gas injection ports, source gas injection ports and purge gas injection ports.

6. A method for coating a surface of a porous substrate by using the apparatus (200) of any of claims 1-5 by generating a flow current inside pores in the porous substrate (220) having a first surface and a second surface opposite to the first surface, which comprises steps of:
transporting the porous substrate (220);
supplying and diffusing a source gas in the direction from the first surface of the porous substrate (220) toward the second surface, and removing reactive by-products and the remaining source after the reaction; and
supplying and diffusing the source gas in the direction from the second surface of the porous substrate (220) toward the first surface, and removing reactive by-products and the remaining source after the reaction.

## Patentansprüche

1. Beschichtungsvorrichtung (200) zum Beschichten einer Oberfläche eines porösen Substrats (220), das eine erste Oberfläche und eine der ersten Oberfläche gegenüberliegende zweite Oberfläche aufweist, die umfasst:
einen ersten Zuführabschnitt (211), um der ersten Oberfläche des porösen Substrats (220) ein Quellgas zuzuführen;
einen ersten Pumpabschnitt (231), um einen Fließstrom in Richtung von der ersten Oberfläche des porösen Substrats zur zweiten Oberfläche innerhalb des porösen Substrats (220) zu erzeugen;
einen zweiten Zuführabschnitt (212), um das Quellgas der zweiten Oberfläche des porösen Substrats (220) zuzuführen;
einen zweiten Pumpabschnitt (232), um einen Fließstrom in Richtung von der zweiten Oberfläche des porösen Substrats zur ersten Oberfläche innerhalb des porösen Substrats (220) zu erzeugen; und
einen Substratträger zum Transportieren des Substrats (220), der zum Transportieren eines diskontinuierlichen Substrats bereitgestellt ist;
worin der erste Zuführabschnitt (211) und der zweite Zuführabschnitt (212) der Reihenfolge nach entlang der Transportrichtung entweder auf dem oberen Teil oder dem unteren Teil des Substrats angeordnet sind und der erste Pumpabschnitt (231) und der zweite Pumpabschnitt (232) entlang der Transportrichtung des Substrats (220) auf dem anderen Teil des oberen Teils oder des unteren Teils des Substrats (220) angeordnet sind,
**dadurch gekennzeichnet, dass**
die Vorrichtung (200) einen Substratumkehrteil zum Umkehren der ersten Oberfläche und der zweiten Oberfläche des Substrats, das durch den ersten Zuführabschnitt (211) verläuft, umfasst und
der Substratträger eine oder mehrere Öffnungen zum Durchlassen des Fließstroms in zumindest einigen Bereichen aufweist.

2. Vorrichtung (200) zum Beschichten einer Oberfläche eines porösen Substrats (220) gemäß Anspruch 1,
worin der erste Zuführabschnitt (211) und der erste Pumpabschnitt (231) auf Basis des Substrats (220) einander zugewandt angeordnet sind.

3. Vorrichtung (200) zum Beschichten einer Oberfläche eines porösen Substrats (220) gemäß Anspruch 1,
worin der zweite Zuführabschnitt (221) und der zweite Pumpabschnitt (232) auf Basis des Substrats (220) einander zugewandt angeordnet sind.

4. Vorrichtung (200) zum Beschichten einer Oberfläche eines porösen Substrats (220) gemäß Anspruch 1,
worin der erste Zuführabschnitt (211) und der zweite Zuführabschnitt (212) der Reihe nach entlang der Transportrichtung des Substrats (200) angeordnet sind und
der erste Pumpabschnitt (231) und der zweite Pumpabschnitt (232) der Reihe nach entlang der Transportrichtung des Substrats (200) angeordnet sind.

5. Vorrichtung (200) zum Beschichten einer Oberfläche eines porösen Substrats (220) gemäß Anspruch 1,
worin der erste Zuführabschnitt (211) Einspritzöffnungen für Vorbehandlungsgas, Einspritzöffnungen für Quellgas und Einspritzöffnungen für Spülgas umfasst.

6. Verfahren zur Beschichtung einer Oberfläche eines porösen Substrats unter Verwendung der Vorrichtung (200) gemäß einem der Ansprüche 1-5 durch Erzeugen eines Fließstroms innerhalb von Poren in dem porösen Substrat (220), das eine erste Oberfläche und eine der ersten Oberfläche gegenüberliegende zweite Oberfläche aufweist, das die folgenden Schritte umfasst:
Transportieren des porösen Substrats (220);
Zuführen und Diffundieren eines Quellgases in Richtung von der ersten Oberfläche des porösen Substrats (220) zur zweiten Oberfläche und Entfernen reaktiver Nebenprodukte und der verbleibenden Quelle nach der Reaktion; und
Zuführen und Diffundieren des Quellgases in Richtung von der zweiten Oberfläche des porösen Substrats (220) zur ersten Oberfläche und Entfernen reaktiver Nebenprodukte und der verbleibenden Quelle nach der Reaktion.

## Revendications

1. Appareil (200) de revêtement pour revêtir une surface d'un substrat (220) poreux présentant une première surface et une deuxième surface opposée à la première surface, qui comprend :
une première partie de fourniture (211) pour fournir un gaz source à la première surface du substrat (220) poreux ;
une première partie de pompage (231) pour générer un courant d'écoulement à l'intérieur du substrat (220) poreux dans la direction allant de la première surface du substrat (220) poreux vers la deuxième surface ;
une deuxième partie de fourniture (212) pour fournir le gaz source à la deuxième surface du substrat (220) poreux ;
une deuxième partie de pompage (232) pour générer un courant d'écoulement à l'intérieur du substrat (220) poreux dans la direction allant de la deuxième surface du substrat (220) poreux vers la première surface ; et
un support de substrat pour transporter le substrat (220) qui est prévu de façon à transporter un substrat discontinu ;
dans lequel la première partie de fourniture (211) et la deuxième partie de fourniture (212) sont disposées dans l'ordre le long de la direction de transport du substrat (220) soit sur la partie supérieure, soit sur la partie inférieure du substrat, et la première partie de pompage (231) et la deuxième partie de pompage (232) sont disposées dans l'ordre le long de la direction de transport du substrat (220) sur l'autre partie de la partie supérieure ou de la partie inférieure du substrat (220),
**caractérisé en ce que**
l'appareil (200) comprend une partie d'inversion de substrat pour inverser la première surface et la deuxième surface du substrat passant à travers la première partie de fourniture (211), et
le support de substrat présente une ou plusieurs ouvertures pour faire passer le courant d'écoulement dans au moins certaines régions.

2. Appareil (200) pour revêtir un substrat (220) poreux selon la revendication 1,
dans lequel la première partie de fourniture (211) et la première partie de pompage (231) sont disposées l'une en face de l'autre sur la base du substrat (220).

3. Appareil (200) pour revêtir un substrat (220) poreux selon la revendication 1,
dans lequel la deuxième partie de fourniture (212) et la deuxième partie de pompage (232) sont disposées l'une en face de l'autre sur la base du substrat (220).

4. Appareil (200) pour revêtir un substrat (220) poreux selon la revendication 1,
dans lequel la première partie de fourniture (211) et la deuxième partie de fourniture (212) sont agencées dans l'ordre le long de la direction de transport du substrat (200), et
la première partie de pompage (231) et la deuxième partie de pompage (232) sont agencées dans l'ordre le long de la direction de transport du substrat.

5. Appareil (200) pour revêtir un substrat (220) poreux selon la revendication 1,
dans lequel la première partie de fourniture (211) comprend des orifices d'injection de gaz de prétraitement, des orifices d'injection de gaz source et des orifices d'injection de gaz de purge.

6. Procédé pour revêtir une surface d'un substrat poreux à l'aide de l'appareil (200) selon l'une quelconque des revendications 1 à 5 par génération d'un courant d'écoulement à l'intérieur de pores dans le substrat (220) poreux présentant une première surface et une deuxième surface opposée à la première surface, qui comprend les étapes consistant à :
transporter le substrat (220) poreux ;
fournir et diffuser un gaz source dans la direction allant de la première surface du substrat (220) poreux vers la deuxième surface, et éliminer des sous-produits réactifs et la source restante après la réaction ; et
fournir et diffuser le gaz source dans la direction allant de la deuxième surface du substrat (220) poreux vers la première surface, et éliminer des sous-produits réactifs et la source restante après la réaction.
